# EUROPEAN PATENT APPLICATION

(11) **EP 1 137 179 A2**
(43) Date of publication of application: **26.09.2001**
(21) Application number: 01300557.4
(22) Date of filing: 22.01.2001
(51) Int. Cl.: H03J 3/08

(54) **Television tuner**

(30) Priority: 23.03.2000 JP 2000087098; 09.05.2000 JP 2000142253
(71) Applicant: ALPS ELECTRIC CO., LTD., Ota-ku Tokyo 145 (JP)
(72) Inventor: Yamamoto, Masaki, Alps Electric Co. Ltd., Tokyo 145 (JP); Furuta, Toshiro, Alps Electric Co. Ltd., Tokyo 145 (JP); Osada, Shigeru, Alps Electric Co. Ltd., Tokyo 145 (JP)
(74) Representative: Kensett, John Hinton

(57) **Abstract**

A television tuner includes a mixer circuit for receiving one of a television signal and an FM broadcast signal, and a local oscillator circuit for inputting a local oscillation signal to the mixer circuit. When the television signal is received, a television intermediate-frequency signal is output from the mixer circuit. Meanwhile, when the FM broadcast signal is received, an FM intermediate-frequency signal having a frequency converted to 10.7 MHz is output from the mixer circuit.

## Description

### BACKGROUND OF THE INVENTION

### 1. Field of the Invention

The present invention relates to a television tuner capable of receiving FM broadcast signals.

### 2. Description of the Related Art

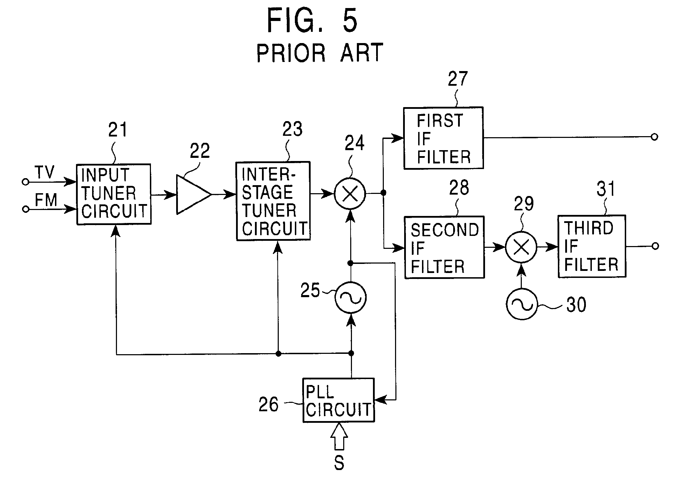

As known in the art, there have been television tuners capable of receiving FM broadcast signals. Fig. 5 illustrates such a known television tuner. Either a television signal, represented by TV, or an FM broadcast signal, represented by FM, is input to an input tuner circuit 21. The input signal is passed to a first mixer circuit 24 through a radio frequency (RF) amplifier circuit 22 and an interstage tuner circuit 23. The first mixer circuit 24 also receives a local oscillation signal output from a first local oscillator circuit 25. The tuned frequency in the input tuner circuit 21 and the interstage tuner circuit 23, and the frequency (local oscillating frequency) of the local oscillation signal output from the first local oscillator circuit 25 are controlled according to a channel select signal S input to a phase-locked loop (PLL) circuit 26, although the local oscillating frequency is always higher than the tuned frequency by the frequency of television intermediate-frequency signal.

For reception of a television signal, therefore, a television intermediate-frequency signal having, e.g., a video intermediate-frequency of 45.75 MHz, according to US standards, is output from the first mixer circuit 24.

Meanwhile, for reception of an FM broadcast signal, an FM broadcast signal (hereinafter referred to as "first FM IF signal") having a frequency converted to the frequency of television intermediate-frequency signal is output therefrom.

The television intermediate-frequency signal output from the first mixer circuit 24 is passed to a subsequent intermediate-frequency circuit (not shown) through a first intermediate-frequency filter 27 for predetermined processing.

The first FM IF signal output from the first mixer circuit 24 is also input to a second mixer circuit 29 through a second intermediate-frequency filter 28. The second mixer circuit 29 also receives a local oscillation signal output from a second local oscillator circuit 30. The frequency of the local oscillation signal output from the second local oscillator circuit 30 is 10.7 MHz higher than the frequency of the first FM IF signal. Therefore, an FM broadcast signal (hereinafter referred to as "second FM IF signal) having a frequency converted to 10.7 MHz is output from the second mixer circuit 29. The second FM IF signal is input to a demodulator circuit (not shown) through a third intermediate-frequency filter 31 to generate an audio signal.

Accordingly, a television tuner typically includes two mixer circuits 24 and 29, and two local oscillator circuits 25 and 30 to achieve two-stage frequency conversion in which an FM broadcast signal is first frequency-converted to the same frequency as the frequency of television intermediate-frequency signal and is then converted to an intermediate-frequency signal having a frequency of 10.7 MHz used in a conventional FM receiver. This prevents a number of beat disturbances between the two kinds of local oscillation signals, resulting in interference during reception.

### SUMMARY OF THE INVENTION

Accordingly, it is an object of the present invention to provide a television tuner including a single mixer circuit and a single local oscillator circuit to provide a simplified layout without interference such as beat disturbances.

To this end, a television tuner includes a mixer circuit for receiving one of a television signal and an FM broadcast signal, and a local oscillator circuit for inputting a local oscillation signal to the mixer circuit. When the television signal is received, a television intermediate-frequency signal is output from the mixer circuit. Meanwhile, when the FM broadcast signal is received, an FM intermediate-frequency signal having a frequency converted to 10.7 MHz is output from the mixer circuit. Therefore, only a single local oscillator circuit is required to obtain both a television intermediate-frequency signal and an FM intermediate-frequency signal having a frequency converted to 10.7 MHz. No beat disturbance occurs between oscillator circuits, thus preventing interference during reception.

Preferably, the television signal or the FM broadcast signal is input through a tuner circuit to the mixer circuit. The frequency of the local oscillation signal and the tuned frequency in the tuner circuit may be changed while the frequency of the local oscillation signal is higher than the tuned frequency by the frequency of the television intermediate frequency signal. In the range where the frequency of the local oscillation signal is 10.7 MHz higher than the frequency of the FM broadcast signal, the tuned frequency may be increased so that the difference between the tuned frequency and the frequency of the local oscillation signal is 10.7 MHz. Therefore, when the television signal is received, a television intermediate-frequency signal is output from the mixer circuit, and when the FM broadcast signal is received, an FM intermediate-frequency signal having a frequency converted to 10.7 MHz is output therefrom.

Preferably, the television tuner further includes a first varactor diode in the tuner circuit to render the tuned frequency variable, and a second varactor diode in the local oscillator circuit to render the frequency of the local oscillation signal variable, the frequency of the local oscillation signal being higher than the tuned frequency by the frequency of the television intermediate-frequency signal while the same voltage is applied to the first varactor diode and to the second varactor diode. In the range where the frequency of the local oscillation signal is 10.7 MHz higher than the frequency of the FM broadcast signal, a higher voltage is applied to the first varactor diode than to the second varactor diode. The difference between the tuned frequency and the frequency of the local oscillation signal may thus be 10.7 MHz.

The television tuner may further include a PLL circuit for outputting a tuning voltage applied to the first varactor diode and to the second varactor diode, a voltage adder circuit, and a voltage supply for supplying a positive voltage, wherein the tuning voltage is applied to the cathode of the second varactor diode and to the voltage adder circuit, and only when the FM broadcast signal is received, the positive voltage is applied to the voltage adder circuit which adds the positive voltage to the tuning voltage, the resulting voltage being applied to the cathode of the first varactor diode.

Alternatively, the television tuner may further include a PLL circuit for outputting a tuning voltage applied to the first varactor diode and to the second varactor diode, and a voltage supply for supplying a negative voltage, wherein the tuning voltage is applied to the cathode of the first varactor diode and to the cathode of the second varactor diode, and the negative voltage is applied to the anode of the first varactor diode only when the FM broadcast signal is received. Therefore, a higher voltage is applied to the first varactor diode.

Preferably, the television signal or the FM broadcast signal is input through a tuner circuit to the mixer circuit. The frequency of the local oscillation signal and the tuned frequency in the tuner circuit may be changed while the frequency of the local oscillation signal is higher than the tuned frequency by the frequency of the television intermediate-frequency signal. In the range where the tuned frequency corresponds to the frequency of the FM broadcast signal, the frequency of the local oscillation signal is lowered so that the difference between the tuned frequency and the frequency of the local oscillation signal is 10.7 MHz. Therefore, when the television signal is received, a television intermediate-frequency signal is output from the mixer circuit, and when the FM broadcast signal is received, an FM intermediate-frequency signal having a frequency converted to 10.7 MHz is output therefrom.

Preferably, the television tuner further includes a first varactor diode in the tuner circuit to render the tuned frequency variable, and a second varactor diode in the local oscillator circuit to render the frequency of the local oscillation signal variable, the frequency of the local oscillation signal being higher than the tuned frequency by the frequency of the television intermediate-frequency signal while the same voltage is applied to the first varactor diode and to the second varactor diode. In the range where the tuned frequency corresponds to the frequency of the FM broadcast signal, a lower voltage is applied to the second varactor diode than to the first varactor diode. The difference between the tuned frequency and the frequency of the local oscillation signal may thus be 10.7 MHz.

The television tuner may further include a PLL circuit for outputting a tuning voltage applied to the first varactor diode and to the second varactor diode, a voltage subtractor circuit, and a voltage supply for supplying a positive voltage, wherein the tuning voltage is applied to the cathode of the first varactor diode and to the voltage subtractor circuit, and only when the FM broadcast signal is received, the positive voltage is applied to the voltage subtractor circuit which subtracts the positive voltage from the tuning voltage, the resulting voltage being applied to the cathode of the second varactor diode.

Alternatively, the television tuner may further include a PLL circuit for outputting tuning voltage applied to the first varactor diode and to the second varactor diode, and a voltage supply for supplying a positive voltage, wherein the tuning voltage is applied to the cathode of the first varactor diode and to the cathode of the second varactor diode, and the positive voltage is applied to the anode of the second varactor diode only when the FM broadcast signal is received. Therefore, a lower voltage is applied to the second varactor diode.

### BRIEF DESCRIPTION OF THE DRAWINGS

A television tuner according to the present invention is described with reference to the accompanying drawings, in which:
Fig. 1 is a block diagram of a television tuner according to a first embodiment of the present invention;
Fig. 2 is a block diagram of a modification of the television tuner according to the first embodiment;
Fig. 3 is a block diagram of a television tuner according to a second embodiment of the present invention;
Fig. 4 is a block diagram of a modification of the television tuner according to the second embodiment; and
Fig. 5 is a block diagram of a conventional television tuner.

### DESCRIPTION OF THE PREFERRED EMBODIMENTS

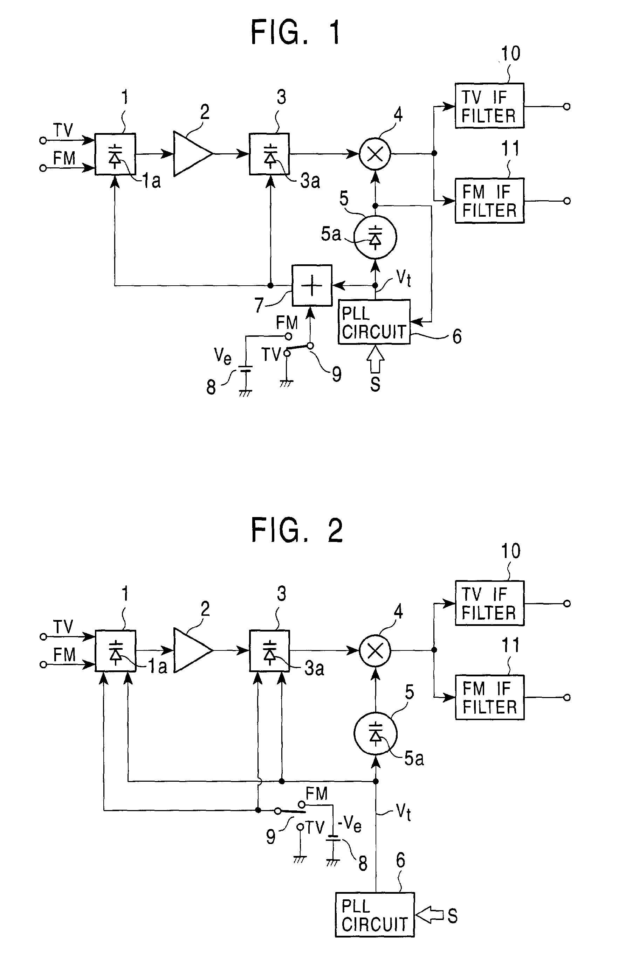

Fig. 1 illustrates a television tuner according to a first embodiment of the present invention. Either a television signal, represented by TV, or an FM broadcast signal, represented by FM, is input to an input tuner circuit 1. The input signal is passed to a mixer circuit 4 through a radio frequency (RF) amplifier circuit 2 and an interstage tuner circuit 3. The mixer circuit 4 also receives a local oscillation signal output from a local oscillator circuit 5. The input tuner circuit 1 and the interstage tuner circuit 3 include first varactor diodes la and 3a, respectively, to render the tuned frequency variable. The local oscillator circuit 5 includes a second varactor diode 5a to render the frequency (local oscillating frequency) of the local oscillation signal variable.

The tuned frequency in the input tuner circuit 1 and the interstage tuner circuit 3, and the local oscillating frequency in the local oscillator circuit 5 are controlled according to tuning voltage Vₜ output from a PLL circuit 6. Specifically, when the same voltage is applied to the first varactor diodes la and 3a and to the second varactor diode 5a, the local oscillating frequency is higher than the tuned frequency by the frequency (intermediate-frequency) of television intermediate-frequency signal.

For reception of a television signal, the same voltage is applied to the first varactor diodes la and 3a and to the second varactor diode 5a. Meanwhile, for reception of an FM broadcast signal, a higher voltage is applied to the first varactor diodes la and 3a than to the second varactor diode 5a so that the difference between the tuned frequency and the local oscillating frequency is 10.7 MHz.

First, therefore, the tuning voltage is applied to the cathode of the second varactor diode 5a in the local oscillator circuit 5, and is also input to a voltage adder circuit 7. The anode of the second varactor diode 5a is grounded at direct current. Only when an FM broadcast signal is received, a voltage supply 8 supplies a positive voltage Vₑ to the voltage adder circuit 7 through a switching unit 9. That is, in the range where the local oscillating frequency is 10.7 MHz higher than the frequency of the FM broadcast signal, the voltage Vₑ is input to the voltage adder circuit 7. The voltage adder circuit 7 then adds the voltage Vₑ to the tuning voltage Vₜ. The resultant voltage is applied to the cathodes of the first varactor diodes la and 3a. The anodes of the first varactor diodes la and 3a are grounded at direct current. The voltage across the first varactor diodes la and 3a is thus increased, making the tuned frequency higher. By setting the voltage Vₑ so that the resulting tuned frequency corresponds to the frequency of the FM broadcast signal, the reception of the FM broadcast signal is achieved. Accordingly, the FM broadcast signal, namely, FM intermediate-frequency signal, having a frequency converted to 10.7 MHz is output from the mixer circuit 4.

Since the voltage supply 8 does not supply a voltage to the voltage adder circuit 7 when a television signal is received, the tuning voltage Vₜ supplied from the PLL circuit 6 is output from the voltage adder circuit 7 without any addition. Accordingly, the mixer circuit 4 outputs an intermediate-frequency signal which becomes a television intermediate-frequency signal (TV intermediate-frequency signal).

The TV intermediate-frequency signal output from the mixer circuit 4 is passed to a subsequent intermediate-frequency circuit (not shown) through a TV intermediate-frequency filter 10 for predetermined processing.

The FM intermediate-frequency signal output from the mixer circuit 4 is passed to a demodulator circuit (not shown) through an FM intermediate-frequency filter 11 to generate an audio signal.

Fig. 2 illustrates a modification of the television tuner according to the first embodiment. The voltage supply 8 supplies a negative voltage -Vₑ. The anodes of the first varactor diodes la and 3a are grounded through resistors (not shown), while the anode of the second varactor diode 5a is directly grounded. The tuning voltage Vₜ output from the PLL circuit 6 is applied to the cathodes of the first varactor diodes la and 3a, and to the cathode of the second varactor diode 5a. In the range where the local oscillating frequency is 10.7 MHz higher than the frequency of FM broadcast signal, the voltage -Vₑ is applied to the cathodes of the first varactor diodes la and 3a through the switching unit 9. The voltage across the first varactor diodes la and 3a is thus increased, making the tuned frequency higher. By setting the voltage -Vₑ, the reception of the FM broadcast signal is achieved. Accordingly, the FM intermediate-frequency signal having a frequency converted to 10.7 MHz is output from the mixer circuit 4.

Since the cathodes of the first varactor diodes la and 3a are grounded through the switching unit 9 when a television signal is received, the input tuner circuit 1 and the interstage tuner circuit 3 are tuned to the frequency of the television signal, so that the mixer circuit 4 outputs a TV intermediate-frequency signal.

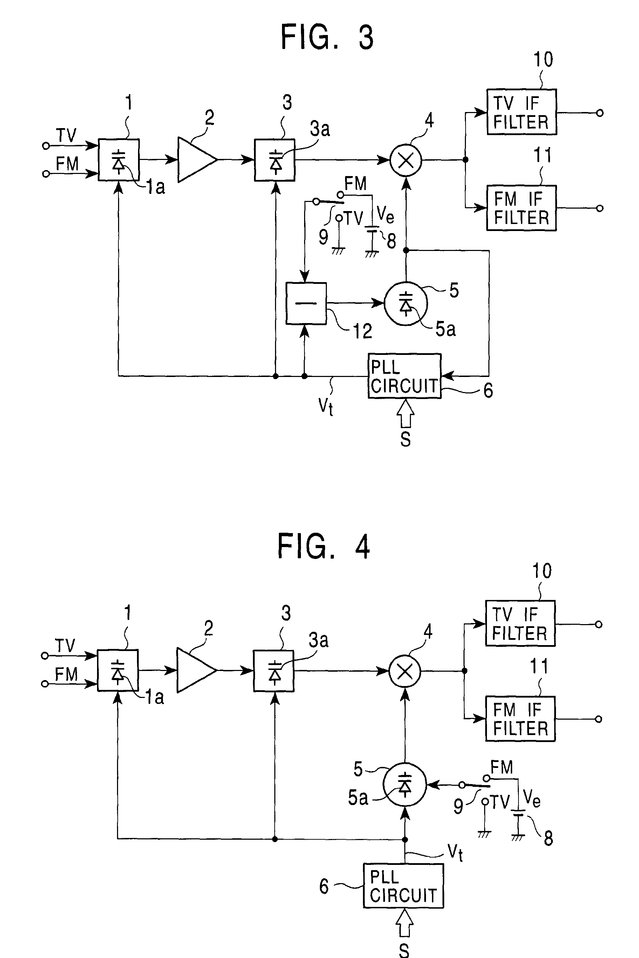

Fig. 3 illustrates a television tuner according to a second embodiment of the present invention. The anodes of the first varactor diodes la and 3a and the anode of the second varactor diode 5a are grounded at direct current. The tuning voltage Vₜ is applied to the cathodes of the first varactor diodes la and 3a, and is also input to a voltage subtractor circuit 12. Only when an FM broadcast signal is received, that is, in the range where the tuned frequency of the tuner circuits 1 and 3 corresponds to the frequency of the FM broadcast signal, the voltage supply 8 supplies a positive voltage Vₑ to the voltage subtractor circuit 12. The voltage subtractor circuit 12 subtracts the voltage Vₑ from the tuning voltage Vₜ and outputs the resulting voltage. The resulting voltage is applied to the cathode of the second varactor diode 5a in the local oscillator circuit 5. This causes the voltage across the second varactor diode 5a to be reduced to provide a lower local oscillating frequency. By setting the voltage Vₑ so that the resulting local oscillating frequency is 10.7 MHz higher than the frequency of the FM signal, an FM intermediate-frequency signal having a frequency converted to 10.7 MHz is output from the mixer circuit 4.

Since the voltage supply 8 does not supply a voltage to the voltage subtractor circuit 12 when a television signal is received, the tuning voltage Vₜ supplied from the PLL circuit 6 is output from the voltage subtractor circuit 12 without any subtraction. Accordingly, the mixer circuit 4 outputs a TV intermediate-frequency signal.

Fig. 4 illustrates a modification of the television tuner according to the second embodiment. The voltage supply 8 supplies a positive voltage Vₑ. The anodes of the first varactor diodes la and 3a are grounded, while the anode of the second varactor diode 5a is grounded through a resistor (not shown) at direct current. The tuning voltage Vₜ output from the PLL circuit 6 is applied to the cathodes of the first varactor diodes 1a and 3a, and to the cathode of the second varactor diode 5a. In the range where the tuned frequency of the input tuner circuit 1 and the interstage tuner circuit 3 corresponds to the frequency of the FM broadcast signal, the voltage Vₑ is applied to the anode of the second varactor diode 5a through the switching unit 9. The voltage across the second varactor diode 5a is thus increased, making the local oscillating frequency lower. By setting the voltage Vₑ so that the resulting oscillating frequency is 10.7 MHz lower than the frequency of the FM broadcast signal, the FM intermediate-frequency signal having a frequency converted to 10.7 MHz is output from the mixer circuit 4.

Since the cathode of the second varactor diode 5a is grounded through the switching unit 9 when a television signal is received, the mixer circuit 4 outputs a TV intermediate-frequency signal.

## Claims

1. A television tuner comprising:
a mixer circuit for receiving as input one of a television signal and an FM broadcast signal; and
a local oscillator circuit for inputting a local oscillation signal to said mixer circuit,
wherein a television intermediate-frequency signal is output from said mixer circuit when the television signal is received, and an FM intermediate-frequency signal having a frequency converted to 10.7 MHz is output from said mixer circuit when the FM broadcast signal is received.

2. A television tuner according to Claim 1, further comprising:
a tuner circuit for receiving one of the television signal and the FM broadcast signal, and through which one of the television signal and the FM broadcast signal is input to said mixer circuit,
wherein the frequency of the local oscillation signal and a tuned frequency in said tuner circuit are changed while the frequency of the local oscillation signal is higher than the tuned frequency by the frequency of the television intermediate-frequency signal, and in the range where the frequency of the local oscillation signal is 10.7 MHz higher than the frequency of the FM broadcast signal, the tuned frequency is increased so that the difference between the tuned frequency and the frequency of the local oscillation signal is 10.7 MHz.

3. A television tuner according to Claim 2, further comprising:
a first varactor diode in said tuner circuit to render the tuned frequency variable; and
a second varactor diode in said local oscillator circuit to render the frequency of the local oscillation signal variable,
the frequency of the local oscillation signal being higher than the tuned frequency by the frequency of the television intermediate-frequency signal while the same voltage is applied to said first varactor diode and to said second varactor diode,
wherein in said range, a higher voltage is applied to said first varactor diode than to said second varactor diode.

4. A television tuner according to Claim 3, further comprising:
a PLL circuit for outputting a tuning voltage applied to said first varactor diode and to said second varactor diode;
a voltage adder circuit; and
a voltage supply for supplying a positive voltage,
wherein the tuning voltage is applied to the cathode of said second varactor diode and to said voltage adder circuit, and only when the FM broadcast signal is received, the positive voltage is applied to said voltage adder circuit which adds the positive voltage to the tuning voltage, the resulting voltage being applied to the cathode of said first varactor diode.

5. A television tuner according to Claim 3, further comprising:
a PLL circuit for outputting a tuning voltage applied to said first varactor diode and to said second varactor diode; and
a voltage supply for supplying a negative voltage,
wherein the tuning voltage is applied to the cathode of said first varactor diode and to the cathode of said second varactor diode, and the negative voltage is applied to the anode of said first varactor diode only when the FM broadcast signal is received.

6. A television tuner according to Claim 1, further comprising:
a tuner circuit for receiving one of the television signal and the FM broadcast signal, and through which one of the television signal and the FM broadcast signal is input to said mixer circuit,
wherein the frequency of the local oscillation signal and a tuned frequency in said tuner circuit are changed while the frequency of the local oscillation signal is higher than the tuned frequency by the frequency of the television intermediate-frequency signal, and in the range where the tuned frequency corresponds to the frequency of the FM broadcast signal, the frequency of the local oscillation signal is lowered so that the difference between the tuned frequency and the frequency of the local oscillation signal is 10.7 MHz.

7. A television tuner according to Claim 6, further comprising:
a first varactor diode in said tuner circuit to render the tuned frequency variable; and
a second varactor diode in said local oscillator circuit to render the frequency of the local oscillation signal variable,
the frequency of the local oscillation signal being higher than the tuned frequency by the frequency of the television intermediate-frequency signal while the same voltage is applied to said first varactor diode and to said second varactor diode,
wherein in said range, a lower voltage is applied to said second varactor diode than to said first varactor diode.

8. A television tuner according to Claim 7, further comprising:
a PLL circuit for outputting a tuning voltage applied to said first varactor diode and to said second varactor diode;
a voltage subtractor circuit; and
a voltage supply for supplying a positive voltage,
wherein the tuning voltage is applied to the cathode of said first varactor diode and to said voltage subtractor circuit, and only when the FM broadcast signal is received, the positive voltage is applied to said voltage subtractor circuit which subtracts the positive voltage from the tuning voltage, the resulting voltage being applied to the cathode of said second varactor diode.

9. A television tuner according to Claim 7, further comprising:
a PLL circuit for outputting a tuning voltage applied to said first varactor diode and to said second varactor diode; and
a voltage supply for supplying a positive voltage,
wherein the tuning voltage is applied to the cathode of said first varactor diode and to the cathode of said second varactor diode, and the positive voltage is applied to the anode of said second varactor diode only when the FM broadcast signal is received.
